(19) Europäisches Patentamt
European Patent Office
Office européen des brevets

(11) **EP 1 026 510 A2**

(12) **EUROPÄISCHE PATENTANMELDUNG**

(43) Veröffentlichungstag:
09.08.2000  Patentblatt 2000/32

(51) Int. Cl.⁷: **G01R 31/01**

(21) Anmeldenummer: **00102427.2**

(22) Anmeldetag: **04.02.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **05.02.1999 DE 19904608**

(71) Anmelder: **Vancura, Vaclav**
**84028 Landshut (DE)**

(72) Erfinder: **Vancura, Vaclav**
**84028 Landshut (DE)**

(74) Vertreter:
**Pausch, Thomas, Dipl.-Phys.**
**Patentanwaltsbüro Pausch**
**Schirmgasse 294**
**84028 Landshut (DE)**

(54) **Vorrichtung zur Überprüfung eines Elektrolyt-Kondensators und Verfahren zur Überprüfung eines Elektrolyt-Kondensators**

(57)    Die Erfindung betrifft eine Vorrichtung zur Prüfung eines in einer Schaltung als Einzelbauelement eingebauten Elektrolyt-Kondensators (2), wobei der zu prüfende Elektrolyt-Kondensator und ein messbereichsbestimmendes Referenzteil (3) eine von einem dem Referenzteil vorgeschalteten Frequenzgenerator (4) gelieferten Wechselspannungssignal (4A) gespeiste Spannungsteilerschaltung bilden, welche ein unmittelbar erzeugtes oder hiervon abgeleitetes Mess-Signal (3A) liefert, das die Betätigung eines der Spannungsteilerschaltung nachgeschalteten Anzeigeelementes (6) steuert, wenn der Scheinwiderstand des zu prüfenden Elektrolyt-Kondensators (2) einen durch das Referenzteil (3) eingestellten entsprechenden Wert unterschreitet. Weiterhin betrifft die Erfindung ein Verfahren zur Prüfung eines in einer Schaltung als Einzelbauelement eingebauten Elektrolyt-Kondensators.

Fig 1

EP 1 026 510 A2

**Beschreibung**

Die Erfindung betrifft eine Vorrichtung zur Prüfung eines Elektrolyt-Kondensators sowie ein Verfahren zur Prüfung eines Elektrolyt-Kondensators.

Defekte oder Fehlverhalten bei elektronischen Schaltungen haben ihre Ursache bei einer großen Anzahl speziell älterer Schaltungen in Kondensatoren, insbesondere Elektrolytkondensatoren, die im Laufe der Zeit einen Teil ihrer Kapazität verloren haben, oder durch Veränderungen Leckströme aufweisen. In der Messtechnik steht man vor dem Problem, dass speziell zur Fehlersuche in einem elektronischen Gerät keine geeigneten praktischen schnell anzuwendenden Messvorrichtungen zur Verfügung stehen, um in einer elektrischen oder elektronischen Schaltung befindliche Kondensatoren auf deren Kapazität zu testen, ohne diese aus dem Schaltungsverbund zeitaufwendig herausnehmen zu müssen. Insbesondere bei der Fehlersuche bei defekten Geräten tritt das Problem auf, dass durch Herstellungsfehler oder Alterungsprozesse in ihrer Kapazität von der Nennkapazität abweichende Kondensatoren nicht ohne weiteres auszumachen sind. Gerade alterungsbedingtes Nachlassen der Kapazität tritt insbesondere bei Elektrolytkondensatoren auf, die durch Altern oder Abdampfen der Elektrolyte stark an Kapazität verlieren können.

Eine hierbei gängige Methode ist, einen zu testenden Kondensator an mindestens einer Elektrodenseite auszulöten, daraufhin den ausgelöteten Kondensator vermittels eines Kapazitätstesters zu prüfen. Da speziell bei älteren Elektrolytkondensatoren Schlüsse zwischen den Kondensatorplatten, die zu einem Leckstrom führen, vorhanden sein können, muss, um eine Aussage über die Funktionalität des Kondensators treffen zu können, auch noch ein Kurzschlusstest oder eine Widerstandsbestimmung vermittels eines zweiten Gerätes oder umständlichen Umschaltens und Umstöpselns an dem Messinstrument durchgeführt werden. Gerade bei komplexeren Schaltungen mit mehreren Elektrolytkondensatoren kann eine solche Vorgehensweise einen großen Zeitaufwand bedeuteten.

Bekannte Vielfachmessinstrumente, mit denen auch die Kapazität eines Kondensators bestimmt werden kann, nutzen hierbei zur Bestimmung der Kapazität den Wechselstromwiderstand eines Kondensators, der durch Anlegen einer geeigneten Wechselspannung bestimmt werden kann. Hierbei muss jedoch bei jeder Messung eine Skala genau abgelesen werden, was bei einem Vielfachinstrument zeitaufwendig ist. Problematisch ist auch, dass die tatsächliche Kapazität der meist polaren Elektrolyt-Kondensatoren nur durch eine Messung der gespeicherten Ladung über die Zeit mit hinreichender Genauigkeit bestimmt werden kann. Die einfachen Kapazitätsmessgeräte und insbesondere die Vielfachmessgeräte sind hierzu unbrauchbar.

Aus der US 4,540,935 ist eine Vorrichtung zur Identifikation defekter Stromverteilerkondensatoren an Hochspannungsmasten bekannt geworden, die eine Hochspannungs-Wechselstromversorgung zur Beaufschlagung eines zu prüfenden nicht ausgebauten Kondensators mit einer niederfrequenten Wechselspannung aufweist, sowie eine Spule als Messeinrichtung für den Strom, der durch den zu prüfenden Kondensator fließt.

Der Erfindung liegt die Aufgabe zugrunde, eine Vorrichtung zur Prüfung eines in einer Schaltung als Einzelbauelement eingebauten Elektrolyt-Kondensators sowie ein Verfahren zur Prüfung eines solchen zur Verfügung zu stellen, bei dem der eingebaute Kondensator in der Schaltung eingebaut bleibt, und mit einem einfach abzulesenden Instrument, auf das Unterschreiten seiner Nennkapazität und auf Leckströme getestet werden kann.

Diese Aufgabe wird durch eine Vorrichtung zur Prüfung eines Elektrolyt-Kondensators nach Anspruch 1 und ein Verfahren zur Prüfung eines Elektrolyt-Kondensators nach Anspruch 14 gelöst.

Erfindungsgemäß ist eine Vorrichtung zur Prüfung eines in einer Schaltung als Einzelbauelement eingebauten Elektrolyt-Kondensators vorgesehen, bei der der zu prüfende Elektrolyt-Kondensator und ein Referenzteil eine von einem dem Referenzteil vorgeschalteten Frequenzgenerator gelieferten Wechselspannungssignal gespeiste Spannungsteilerschaltung bilden, welche ein unmittelbar erzeugtes oder hiervon abgeleitetes Mess-Signal liefert, das die Betätigung eines der Spannungsteilerschaltung nachgeschalteten Anzeigeelementes steuert, wenn der Scheinwiderstand des zu prüfenden Elektrolyt-Kondensators einen durch das Referenzteil eingestellten entsprechenden Wert unterschreitet bzw. überschreitet.

Die Erfindung umfasst somit eine Spannungsteilerschaltung mit einem Referenzteil und dem zu prüfenden Elektrolyt-Kondensator, um an dem Elektrolyt-Kondensator die nach dessen Scheinwiderstand abfallende Wechselspannung zu messen. Hierzu wird an den Spannungsteiler eine Wechselspannung angelegt und bei Unterschreiten bzw. Überschreiten eines vorbestimmten Potenzials der am Elektrolyt-Kondensator abfallenden Wechselspannung ein Anzeigeelement betätigt. Dadurch muss nicht mehr ein konkreter Wert abgelesen werden, sondern nur auf die Betätigung des Anzeigeelements geachtet werden, welches ein Unter- bzw. Überschreiten einer durch das Referenzteil vorgegebenen Kapazität des zu prüfenden Kondensators meldet.

Damit die abfallenden Wechselspannung als Mess-Signal am zu prüfenden Elektrolyt-Kondensator abgreifbar wird, ist in einer besonders bevorzugten Ausgestaltung der Erfindung der zu prüfende Elektrolyt-Kondensator und das Referenzteil in Reihe geschaltet, und das Mess-Signal ist am Verbindungsknoten der einen Elektrode des zu prüfenden Elektrolyt-Kondensators und des Referenzteil abgegriffen. Vorteilhafterweise ist hierzu die zweite Elektrode des zu prüfenden Kondensators mit einem Referenzpotenzial (Masse) gekoppelt.

In einer weiterhin besonders bevorzugten Ausgestaltung der Erfindung ist dem Anzeigeelement eine Pegelauswerteschaltung vorgeschaltet, die die elektrische Spannung des an Spannungsteiler abgegriffenen Mess-Signals bewertet und im Falle des Unterschreitens bzw. Überschreitens eines vorbestimmten Spannungsniveaus des Mess-Signals an ihrem Ausgang ein Ergebnissignal liefert, das das Anzeigeelement steuert. Vorteil hierbei ist, dass beliebige Anzeigeelemente verwendet werden können, und die angelegte Wechselspannung niedrig genug sein kann, um nicht die elektronische Schaltung, die den zu prüfenden Elektrolyt-Kondensator beinhaltet, zu beschädigen oder zu zerstören.

Nach einer Ausgestaltung der Erfindung ist das Referenzteil durch einen Widerstand, insbesondere einen komplexen Widerstand, ausgebildet.

Gemäß einer besonders bevorzugten Ausführung der Erfindung weist der zu prüfende Elektrolyt-Kondensator eine Nennkapazität von 1 bis 1000 µF auf.

Von Vorteil ist die Pegelausworteschaltung durch eine Verstärkerschaltung und/oder eine digitale Inverterschaltung gebildet. Hierdurch kann mit sehr einfachen und billigen Mitteln eine Verstärkerschaltung realisiert werden.

Eine bevorzugte Ausführungsform der Erfindung sieht vor, dass die Pegelausworteschaltung durch einen Prozessor, insbesondere einen integrierten Signalprozessor, gebildet ist. Hierdurch kann eine Reihe von Spannungspegeln als Schaltschwellen gewählt werden, wodurch ein schnelles und sicheres Prüfen ermöglicht wird.

Bei einer vorteilhaften Ausführungsform ist dem Prozessor eine Pegelverstärkungsschaltung vorgeschaltet. Hierdurch werden Beschädigungen des Prozessors vermieden und das Mess-Signal auf ein besser zu verarbeitendes Potential angehoben.

Der Frequenzgenerator ist nach einer Weiterbildung der Erfindung eine selbsterregende Oszillatorschaltung.

Nach einer weiteren, ebenso vorteilhaften Weiterbildung der Erfindung ist der Frequenzgenerator im Prozessor integriert ist.

Eine besonders vorteilhafte und daher bevorzugte Ausführungsform der Erfindung sieht vor, dass eine Widerstandstest-Schaltung zur Ermittlung des (realen) Gleichstromwiderstands des zu prüfenden Kondensators vorgesehen ist.

Eine Weiterbildung der Erfindung sieht vor, dass die Widerstandstest-Schaltung einen Referenzwiderstand aufweist, der mit dem zu prüfenden Elektrolyt-Kondensator eine von einer dem Referenzwiderstand vorgeschalteten Gleichspannungseinheit gelieferten Gleichspannung gespeiste Gleichspannungs-Spannungsteilerschaltung bildet, welche ein unmittelbar erzeugtes oder hiervon abgeleitetes Gleichspannungs-Mess-Signal liefert, das die Betätigung eines der Gleichspannungs-Spannungsteilerschaltung nachgeschalteten zweiten Anzeigeelementes steuert, wenn der Serienwiderstand des zu prüfenden Elektrolyt-Kondensators einen durch den Referenzwiderstand eingestellten entsprechenden Wert unterschreitet.

In einer weiterhin bevorzugten Ausgestaltung der Erfindung ist dem zweiten Anzeigeelement eine Gleichspannungpegelausworteschaltung vorgeschaltet, die die elektrische Spannung des Gleichstrom-Mess-Signals bewertet und im Falle eines Unterschreitens eines vorbestimmten Spannungsniveaus des Gleichstrom-Mess-Signals das zweite Anzeigeelement steuert. Vorteil ist wiederum die Möglichkeit, ein beliebiges Anzeigeelement unabhängig von dessen benötigter Ansteuerspannung zu verwenden.

Vorteilhafterweise ist dass ein Verteiler vorgesehen, der das Kontaktorgan entweder mit dem Referenzteil und somit den zu prüfenden Kondensator mit der Wechselspannung des Frequenzgenerators beaufschlagt oder das Kontaktorgan mit dem Referenzwiderstand und somit mit der Gleichspannung der Gleichspannungseinheit verbindet. Dem folgend kann der Verteiler durch ein Schalter- oder ein Transistorpaar ausgebildet sein.

In weiterer Ausgestaltung der Erfindung ist eine Restladungstest-Schaltung vorgesehen, die eine elektrische Ladung des zu prüfenden Elektrolyt-Kondensators detektiert und an ihrem Ausgang ein entsprechendes Signal liefert. Hierdurch wird die Detektion von Restladung des zu prüfenden Elektrolyt-Kondensators ermöglicht, was insbesondere bei großen Kapazitäten und hohen Ladespannungen eine Gefahrenquelle für die Vorrichtung darstellt bzw. zu Fehlmessungen führen kann. Bei Feststellen einer Ladung wird die Messung abgebrochen und/oder eine entsprechende Anzeige erfolgt.

Von Vorteil ist der Prozessor mit der Restladungstest-Schaltung und/oder mit der Widerstandstest-Schaltung verbunden und steuert entsprechend deren Signale die Anzeigevorrichtung. Hierdurch können die einzelnen Teil-Messungen bzw. -Ergebnisse zu einer Bewertung zusammengefasst werden.

Vorteilhafterweise ist in einer weiteren besonders bevorzugten Ausgestaltung der Erfindung ein Kontaktorgan vorgesehen, vermittels welchem die wechselspannung und/oder die Gleichspannung an die eine Elektrode des zu prüfenden Elektrolyt-Kondensators zugeführt ist und das insbesondere durch eine elektrisch mit der Vorrichtung verbundene metallene Messspitze ausgebildet ist, welche mit der einen Elektrode des zu prüfenden Elektrolyt-Kondensators in Kontakt gebracht ist.

Gemäß einer vorteilhaften Ausgestaltung der Erfindung ist vorgesehen, dass das Anzeigeelement und/oder das zweite Anzeigeelement oder die optischen Anzeigeeinheiten Leuchtdioden (LED = light emitting diode) oder eine vermittels eines Transistors getriebene Leuchtdiode ist.

Die Erfindung betrifft ferner ein Verfahren zur Prüfung eines Elektrolyt-Kondensators, der in einer Schaltung als Einzelbauelement eingebaut ist, wobei die eine Elektrode des Elektrolyt-Kondensators mit einem Prüfsignal beaufschlagt wird, und die andere Elektrode auf ein Bezugspotential (Masse) gesetzt wird. Dabei wird der zu prüfende Elektrolyt-Kondensator, der im eingebauten Zustand belassen wird, an einer seiner Elektroden mit einer hochfrequenten Wechselspannung als Prüfsignal beaufschlagt, welche aufgrund des Scheinwiderstandes des Elektrolyt-Kondensators an diesem einen Spannungsabfall hat, der ein Anzeigeelement steuert. Dabei zeigt das Anzeigeelement ein Unter- oder Überschreiten einer durch ein Referenzteil festgelegten Schwellspannung, der durch den Scheinwiderstand abfallenden Spannung an.

Vorteilhafterweise wird die am Kondensator abfallende Spannung vermittels einer dem Anzeigeelement vorgeschalteten Verstärkereinrichtung verstärkt.

In einem besonders bevorzugten Verfahrensschritt wird die Schwellspannung, die bei einer Unter- oder Überschreitung zur Anzeige des Signals durch das Anzeigeelement führt, durch das Referenzteil einstellt. Somit wird der Scheinwiderstand und damit die tatsächliche Kapazität, der zur Auslösung des Signals führt in Schwellen von beispielsweise 5µF, 10µF, 50µF usw. festgelegt. Dem folgend wird bevorzugt als zu prüfender Kondensator ein Elektrolytkondensator mit einer Nennkapazität von 1 bis 1000µF verwendet.

Gemäß eines weiteren bevorzugten Verfahrensschritts ist das Prüfsignal eine Gleichspannung die aufgrund des Serienwiderstandes am Kondensators eine abfallende Spannung erzeugt, die das erste oder ein zweites Anzeigeelement steuert, wobei das Anzeigeelement ein Unter- oder Überschreiten einer durch einen Referenzwiderstand festgelegten Schwellspannung der durch den Serienwiderstand des Kondensators an diesem abfallenden Spannung durch ein Signal anzeigt.

Vorteilhafterweise werden die das erste und/oder das zweite Anzeigeelement steuernden Signale durch einen Prozessor verarbeitet und/oder zwischengespeichert und zu einer Gesamtbewertung weiterverarbeitet, wobei von Vorteil zuerst die Ladung, danach der Gleichstromwiderstand und hierauf der Scheinwiderstand des zu prüfenden Elektrolyt-Kondensators ermittelt und bewertet wird.

Weitere Vorteile, Besonderheiten und zweckmäßige Weiterbildungen der Erfindung ergeben sich aus den Unteransprüchen.

Ein bevorzugtes Ausführungsbeispiel der Erfindung wird nachfolgend anhand der Zeichnung erläutert. Es zeigt:

Figur 1      ein Schaltbild einer erfindungsgemäßen Vorrichtung zur Prüfung eines Elektrolyt-Kondensators; und

Figur 2      ein Schaltbild einer erfindungsgemäßen Vorrichtung mit einem Prozessor.

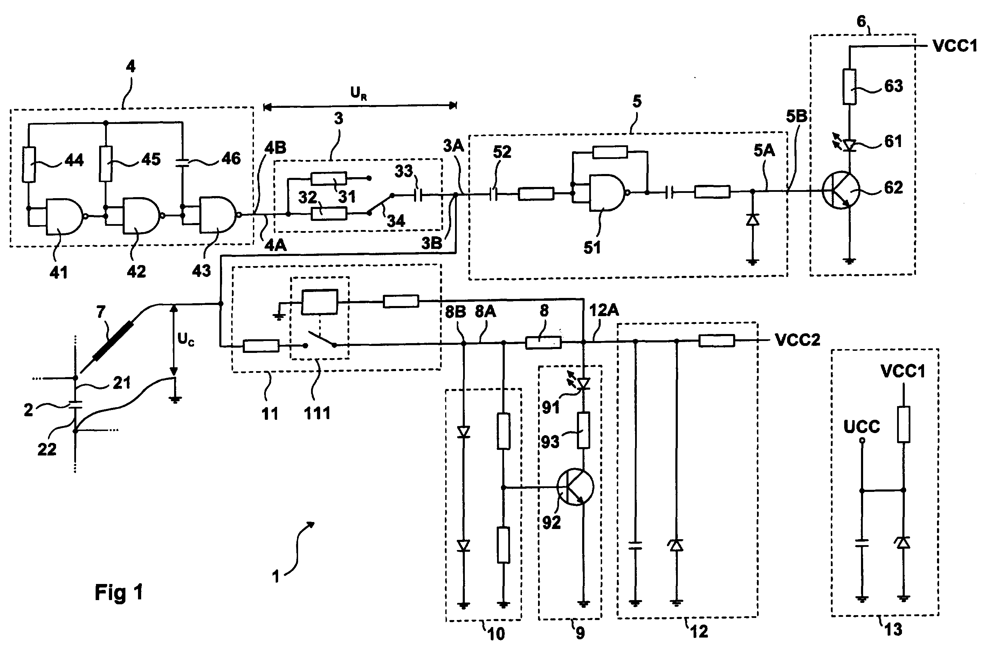

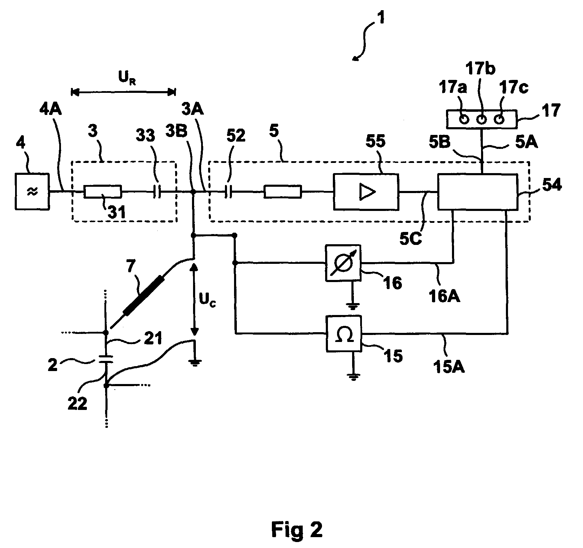

In Figur 1 und 2 gleiche Bezugszeichen bezeichnen gleiche oder gleich wirkende Schaltungselemente.

Das in Figur 1 dargestellte Ausführungsbeispiel einer erfindungsgemäßen Vorrichtung 1 zur Prüfung eines in einer Schaltung als Einzelbauelement eingebauten Kondensators 2 umfasst zwei Schaltungsteile, ein Kapazitätstest-Schaltungsteil und ein Widerstandstest-Schaltungsteil. Das Kapazitätstest-Schaltungsteil beinhaltet einen Frequenzgenerator 4, ein Referenzteil 3, eine Pegelauswerteschaltung 5 für das Mess-Signal 3A und ein Anzeigeelement 6.

Das Widerstandstest-Schaltungsteil beinhaltet einen Referenzwiderstand 8 eine Gleichspannungspegelauswerteschaltung 10 zur Bewertung des Gleichspannungs-Mess-Signals 8A sowie ein Anzeigeelement 9.

Erfindungsgemäß wird vermittels dem Referenzteil 3 und dem zu prüfenden Kondensator 2 ein Spannungsteiler gebildet. Hierzu wird der zu prüfende Kondensator 2 mit seiner einen Elektrode 21 mit dem als Messspitze ausgebildeten Kontaktorgan 7 mit dem Verbindungsknoten 3B des Spannungsteilers, der durch den Ausgang des Referenzteils 3 gebildet wird, verbunden. Die andere Elektrode 22 des zu prüfenden Kondensators 2 wird mit der gemeinsamen Masse der Vorrichtung 1 verbunden. Der so entstandene Spannungsteiler wird mit der durch den Frequenzgenerator 4 gelieferten Prüfspannung $U_P$ beaufschlagt. Die an dem Kondensator 2 abfallende Spannung wird dann als Mess-Signal 3A gemessen.

Um die Kapazität des Kondensators zu bestimmen, wird die Beziehung des Scheinwiderstandes Z nach

$$Z=\sqrt{R_S{}^2 + X_C{}^2}$$

ausgenutzt. Nach dieser setzt sich der Scheinwiderstand Z eines Kondensators aus dem Wechselstromwiderstand $X_C$ und dem Serienwiderstand $R_S$ zusammen. Hierbei gilt der folgende Zusammenhang mit der Kapazität C des Kondensators und der Frequenz $\omega$ der angelegten Wechselspannung:

$$X_C = \frac{1}{\omega C}.$$

Dies stellt jedoch nur den rein theoretischen Wert dar. Die Einflüsse der Bauform und der Materialien aus denen der zu prüfende Elektrolyt-Kondensator aufgebaut ist gehen hier nicht ein und sind nur sehr schwer zu berechnen. Diese Parameter gehen durch eine geeignete - empirisch ermittelte - Wahl der Referenzwiderstände in die Bestimmung mit ein.

In der erfindungsgemäßen Schaltung ist vorgesehen, dass der Frequenzgenerator 4 mit einer festen Frequenz und gleich bleibender Leistung betrieben wird. Der Betrag der am zu prüfenden Kondensator im Spannungsteiler abfallenden Spannung wird also durch den Wechselstromwiderstand des Referenzteils 3 festgelegt.

Die außen am Spannungsteiler anliegende vom Frequenzgenerator gelieferte Prüfspannung $U_P$ teilt sich also auf den Widerstand 3 und den Scheinwiderstand des Kondensators 2 zu

$$U_P = U_R + U_C$$

auf. Da der gleiche Strom $I_C$ durch den Widerstand 31 oder 32 des Referenzteils 3 und den zu prüfenden Kondensator 2 vom Frequenzgenerator 4 zur Masse fließt, kann das Ohmsche Gesetz für beide Teile des Spannungsteiles mit $I_C$ angewendet werden. $U_P$ ergibt sich zu

$$U_P = I_C \cdot R_R + I_C \cdot Z.$$

Löst man weiter nach der am Kondensator abfallenden Spannung $U_C$ auf, die dem Mess-Signal 3A entspricht, das durch die Pegelauswerteschaltung 5 ausgewertet wird, so folgt

$$U_C = U_P - U_R = U_P - I_C \cdot R_R = U_P - R_R \cdot \frac{U_C}{Z},$$

was nach Einsetzen der Formel für den Scheinwiderstand Z und den Wechselstromwiderstand $X_C$ für die am zu prüfenden Kondensator abfallende Spannung $U_C$ folgenden Zusammenhang ergibt:

$$U_C = \frac{U_P}{1 + \frac{R_R}{Z}} = U_P \cdot \left(1 + R_R \cdot \left(R_S^2 + \frac{1}{(\omega C)^2}\right)^{-\frac{1}{2}}\right)^{-1}.$$

Hieraus kann vermittels der Parameter des Widerstandes des Referenzteiles $R_R$ und der Frequenz $\omega$ der Wechsel- oder Prüfspannung $U_P$ die in diesem Fall als fest zu 500 kHz gewählt wird, die Kapazität C bestimmt werden bzw. die abfallende Spannung $U_C$ bei vorgegebener Kapazität C bestimmt werden.

Der Scheinwiderstand des Referenzteils 3 bestimmt hiernach bei gleich gewählter Kapazität C das Teilungsverhältnis des Spannungsteilers. Ist der Widerstand des Referenzteils 3, wie im Schaltungsbeispiel, ein ohmscher Widerstand, so ist dieser bei geeigneter Bauart nicht frequenzabhängig.

Die Pegelauswerteschaltung 5 ist durch ihren konstruktiven Merkmale so ausgestaltet, dass bei Überschreiten einer Schwell- oder Schaltspannung am Ausgang der Pegelauswerteschaltung 5 ein Ergebnissignal 5A ausgegeben wird. Vermittels dieses Ergebnissignal wird das der Pegelauswerteschaltung 5 nachgeschaltete Anzeigeelement 6 gesteuert.

Das als einstellbarer Widerstand ausgebildete Referenzteil 3, dessen Widerstand durch einen der beiden Widerstände 31 oder 32 je nach Schaltzustand eines Umschalters 34 festgelegt ist, legt somit die Kapazität des Kondensators fest, die zum Erreichen der Schwell- oder Schaltspannung der Pegelauswerteschaltung 5 notwendig ist.

Somit werden Bereiche eines an Spannungsteiler anliegenden Scheinwiderstandes Z einer zu prüfenden Kapazität C geschaffen die entweder über oder unter der Schwell- oder Schaltspannung der Pegelauswerteschaltung 5 liegen und somit zu einem Signal führen oder nicht.

Die Pegelauswerteschaltung 5 ist durch einen als Verstärker und bei erreichen einer Schaltspannung als Schalter arbeitenden Inverter 51 ausgebildet, der eingangsseitig durch einen Abblockkondensator 52 vor einer noch eventuell im zu prüfenden Kondensator verbliebenen Restladung geschützt wird. Ist eingangsseitig die zum Kippen des Inverters 51 notwendige Schaltspannung durch die am Scheinwiderstand des Kondensators abfallende Spannung $U_C$ erreicht, so wird am Ausgang der Pegelauswerteschaltung ein Ergebnissignal 5B geliefert und das Anzeigeelement 6 wird angesteuert. Der Inverter 51 kann, wie im Beispiel gezeigt, durch ein NAND-Gatter mit zusammengeschalteten Eingängen ausgebildet sein.

Mit der oben angegebenen Beziehung für die am Kondensator abfallende Spannung $U_C$ können auch die Schwell- oder Schaltspannungen für das Mess-Signal 3A oder die notwendigen Widerstandswerte $R_R$ der einzelnen Widerstände des Referenzteils 3 berechnet bzw. festgelegt werden.

So ist die Schaltschwelle für kleine Kapazitäten von typischerweise wenigen μF ebenso einstellbar wie für große Kapazitäten bis zu 1000μF.

Das Anzeigeelement 6 des Kapazitätstest-Schaltungsteils setzt sich dabei aus einer Leuchtdiode 61 einem Widerstand 63 zur Bereitstellung der Betriebsspannung für die Leuchtdiode 61 und einem Treibertransistor 62 zusammen. In der gleichen Art und Weise ist auch das zweite Anzeigeelement 9 des Widerstandstest-Schaltungsteils mit einer Leuchtdiode 91 einem Widerstand 93 und einem Treibertransistor 92 aufgebaut.

Der Frequenzgenerator ist hierbei als selbsterregender Oszillator mit einer Festfrequenz ausgelegt. Drei hintereinander geschaltete Inverter 41 bis 43 werden durch geeignet gewählte Rückkoppelelemente 44 bis 46 zu einer Schwingung am Ausgang 4B des Frequenzgenerators 4 von vorzugsweise 500kHz angeregt. Das Wechselspannungssignal 4A mit einer solchen Frequenz ist besonders geeignet für den Bereich der Elektrolytkondensatoren mit typischen Kapazitäten von 1 bis 1000μF. Die Inverter 41 bis 43 sind im Schaltungsbeispiel durch NAND-Gatter mit zusammengeschalteten Eingängen ausgebildet.

Das Referenzteil 3 ist durch zwei in ihrem Wert unterschiedliche Widerstände 31 und 32 sowie durch einen Umschalter 34 ausgebildet. Der Umschalter kann hierzu als Kippschalter oder Drehschalter ausgebildet sein. Es können auch weitere Widerstände mit weiteren unterschiedlichen Widerstandswerten vorgesehen sein, um so weitere Schwellspannungen, die bestimmten Kapazitäten entsprechen, durch ein verändertes Teilungsverhältnis des Spannungsteilers zur Verfügung zu stellen.

Um den Frequenzgenerator 4 vor einer möglicherweise im zu prüfenden Kondensator 2 verbliebenen Restladung zu schützen, ist ein Abblockkondensator 33 vor den Verbindungsknoten 3B des Referenzteils 3 und des zu prüfenden Kondensators 2 am Ausgang des Referenzteils 3 vorgesehen.

Zur Bereitstellung der Betriebsspannung UCC für die Inverter oder als solche geschalteten NAND-Gatter 41 bis 43 und 51 ist eine Stabilisierungsschaltung 13 vorgesehen, die die Versorgungsspannung VCC1, die auf einer für die Inverter zu hohen Spannung liegen kann auf die Inverter-Betriebsspannung UCC reduziert. Hierzu wird eine Standardschaltung mit einer Zenerdiode verwendet.

Die Gleichspannung 12A des Kapazitätstest-Schaltungsteils wird von einer Gleichspannungseinheit 12 geliefert, die in ihrem Aufbau gleich mit der Stabilisierungsschaltung 13 ist. Diese Gleichspannungseinheit 12 ist von einer Versorgungsspannung VCC2 gespeist.

Damit der Serienwiderstand $R_S$ des zu prüfenden Kondensators 2 mit dem der Gleichspannungseinheit 12 nachgeschalteten Referenzwiderstand 8 einen Spannungsteiler bilden kann, ist ein Verteiler 11 vorgesehen. Dieser ein Relais 111 beinhaltende Verteiler 11 verbindet bei anliegen der Versorgungsspannung VCC2 das Kontaktorgan 7 mit dem Referenzwiderstand 8.

Hierzu ist die Versorgungsspannung im Widerstandstestbetrieb anzuschalten und im Kapazitätstestbetrieb abzuschalten. Dies kann durch einen Öffner für die Versorgungsspannung VCC2 oder einen Umschalter, der entweder die Versorgungsspannung VCC1 auf das Kapazitätstest-Schaltungsteil oder die Versorgungsspannung VCC2 auf das Widerstandstest-Schaltungsteil aufschaltet erfolgen.

Das am Verbindungsknoten 8B abgegriffene Gleichspannungs-Mess-Signal 8A der von dem Referenzwiderstand 8 und dem Serienwiderstand des zu prüfenden Kondensators 2 gebildeten Gleichspannungs-Spannungsteilerschaltung wird durch eine Gleichspannungspegelauswerteschaltung 10, die durch einen weiteren Spannungsteiler ausgebildet ist, ausgewertet. Die Gleichspannungspegelauswerteschaltung 10 steuert ein zweites mit dem Anzeigeelement 6 baugleiches Anzeigeelement 9 an, wenn das Gleichspannungs-Mess-Signals 8A ein durch das Teilungsverhältnis des Spannungsteilers der Gleichspannungspegelauswerteschaltung 10 vorbestimmtes Spannungsniveau unterschreitet. Ist der Serienwiderstand $R_S$ des zu prüfenden Kondensators 2 zu klein so wird das zweite Anzeigeelement 9 erlöschen. Dadurch ist ein Schluss zwischen den Elektroden 21 und 22 des Kondensators 2 in Form eines zu großen Leckstromes sicher festgestellt.

Das vorbestimmte Spannungsniveau wird durch den Referenzwiderstand 8 bestimmt. Der Referenzwiderstand 8 ist dabei so eingestellt, dass die Betätigung des zweiten Anzeigeelementes 9 erfolgt, wenn der Serienwiderstand $R_S$ des zu prüfenden Kondensators 2 einen durch den Referenzwiderstand 8 eingestellten entsprechenden Wert unterschreitet.

In Figur 2 ist eine weitere erfindungsgemäße Vorrichtung zur Prüfung eines in einer Schaltung als Einzelbauelement eingebauten Elektrolyt-Kondensators 2 mit einem Kapazitätstest-Schaltungsteil, einem Widerstandstest-Schaltungsteil 15 (Signal 15A) und einem Restladungstest-Schaltungsteil 16 (Signal 16A). Das Kapazitätstest-Schaltungsteil beinhaltet wiederum den Frequenzgenerator 4, das Referenzteil 3, die und Pegelauswerteschaltung 5 zur Mess-Wert-Aufbereitung und -Bewertung; jedoch findet hier die Pegelauswertung und Ansteuerung des Anzeigeelements 17 durch den Prozessor 54 statt. Das Messsignal wird durch einen dem Prozessor 54 vorgeschalteten Pegelverstärkungsschaltung 55 zu durch den Prozessor besser zu verarbeitenden Pegeln angehoben.

Weiterhin ist nunmehr eine Verbindung des Widerstandstest-Schaltungsteils 15 mit dem die Anzeige ansteuernden Prozessor 54 vorgesehen. Die Restladungstest-Schaltung 16, die ebenfalls mit dem Prozessor 54 verbunden ist, dient zur Detektion von Restladungen in den zu testenden Elektrolyt-Kondensator 2, wobei bei detektierter Restladung (vermittels des Signals 16A) die weiteren Mess-Schritte - Gleichstrom-Widerstandsbestimmung und Wechselstrom-Widerstandsbestimmung - durch den Prozessor nicht mehr eingeleitet werden, da die Messungen infolge der Ladung zu Fehlergebnissen führen würden. Eine entsprechende Anzeige am Anzeigeelement bzw. an der Anzeigevorrichtung 17 erfolgt hierauf durch den Prozessor. Der Prozessor kann durch einen programmierbaren Signalprozessor ausgebildet sein.

Das Referenzteil 3 ist in diesem Bespiel - anders als in dem in Figur 1 dargestellten - ein fester nicht mehr manuell wählbarer Widerstand. Die Einstellung der Bewertungsschwellen, und damit die Kapazität des Kondensators, die zum Erreichen der Schwell- oder Schaltspannung und damit zur positiven oder negativen Beurteilung führt, erfolgt durch den Prozessor bzw. durch das durch diesen ausgeführte Messprogramm. Das Messprogramm bestimmt zuerst die Restladung, dann wird die Gleichstrom-Widerstandsbestimmung und hierauf die Wechselstrom-Widerstandsbestimmung vorgenommen. Die einzelnen Teilmessungen werden zu einem Ergebnis zusammengefasst und angezeigt.

Der Frequenzgenerator 4 kann wieder durch eine Schaltung wie im ersten Beispiel nach Figur 1 beschrieben ausgebildet sein. Es ist jedoch auch möglich, dass der Frequenzgenerator im Prozessor integriert ist. Die Schwingung von vorzugsweise 500kHz wird dann am Ausgang des Prozessors 54 abgegriffen.

Das erste und zweite Anzeigeelement (6 und 9) aus dem Beispiel nach Figur 1 ist in der Ausführung nach Figur 2 durch eine Anzeigevorrichtung 17 mit drei einzelnen optischen Anzeigeeinheiten 17a bis 17c ausgebildet. Die optischen Anzeigeeinheiten können wieder Leuchtdioden (LED = light emitting diode) oder vermittels eines Transistors getriebene Leuchtdioden sein.

Durch die vermittels des Prozessors gesteigerte Funktionalität der Anzeigevorrichtung sind komplexere Ergebnis- und Zustandsanzeigen möglich. So kann als Anzeigevorrichtung beispielsweise auch ein Text-Display Anwendung finden.

## Patentansprüche

1. Vorrichtung zur Prüfung eines in einer Schaltung als Einzelbauelement eingebauten Elektrolyt-Kondensators (2), wobei der zu prüfende Elektrolyt-Kondensator und ein Referenzteil (3) eine von einem dem Referenzteil vorgeschalteten Frequenzgenerator (4) gelieferten Wechselspannungssignal (4A) gespeiste Spannungsteilerschaltung bilden, welche ein unmittelbar erzeugtes oder hiervon abgeleitetes Mess-Signal (3A) liefert, das die Betätigung eines der Spannungsteilerschaltung nachgeschalteten Anzeigeelementes (6) steuert, wenn der Scheinwiderstand des zu prüfenden Elektrolyt-Kondensators (2) einen durch das Referenzteil (3) eingestellten entsprechenden Wert unterschreitet.

2. Vorrichtung nach Anspruch 1,
   dadurch **gekennzeichnet**,
   dass der zu prüfende Elektrolyt-Kondensator (2) und das Referenzteil (3) in Reihe geschaltet sind und das Mess-Signal (3A) am Verbindungsknoten (3B) der einen Elektrode (21) des zu prüfenden Elektrolyt-Kondensators (2) und des Referenzteils (3) abgegriffen ist.

3. Vorrichtung nach Anspruch 1 oder 2,
   dadurch **gekennzeichnet**,
   dass dem Anzeigeelement (6) eine Pegelauswerteschaltung (5) vorgeschaltet ist, die die elektrische Spannung des Mess-Signals (3A) bewertet und im Falle eines Unterschreitens eines vorbestimmten Spannungsniveaus ein Ergebnissignal (5A) an ihrem Ausgang (5B) liefert, das das Anzeigeelement (6) steuert.

4. Vorrichtung nach Anspruch 3,
   dadurch **gekennzeichnet**,
   dass die Pegelauswerteschaltung (5) durch eine Verstärkerschaltung und/oder eine digitale Inverterschaltung (51) gebildet ist.

5. Vorrichtung nach Anspruch 3,
   dadurch **gekennzeichnet**,
   dass die Pegelauswerteschaltung (5) durch einen Prozessor (54), insbesondere einen integrierten programmierbaren Signalprozessor, gebildet ist.

**6.** Vorrichtung nach einem der Ansprüche 1 bis 5,
dadurch **gekennzeichnet**,
dass der Frequenzgenerator (4) eine selbsterregende Oszillatorschaltung ist, die insbesondere im Prozessor (51) integriert ist.

**7.** Vorrichtung nach einem der Ansprüche 1 bis 6,
dadurch **gekennzeichnet**,
dass eine Widerstandstest-Schaltung (15, 10 und 8) vorgesehen ist, die einen Referenzwiderstand (8) aufweist, der mit dem zu prüfenden Elektrolyt-Kondensator (2) eine von einer dem Referenzwiderstand vorgeschalteten Gleichspannungseinheit (12) gelieferten Gleichspannung (12A) gespeiste Gleichspannungs-Spannungsteilerschaltung bildet, welche ein unmittelbar erzeugtes oder hiervon abgeleitetes Gleichspannungs-Mess-Signal (8A, 15A) liefert, das die Betätigung eines der Gleichspannungs-Spannungsteilerschaltung nachgeschalteten zweiten Anzeigeelementes (9) steuert, wenn der Serienwiderstand des zu prüfenden Elektrolyt-Kondensators (2) einen durch den Referenzwiderstand (8) eingestellten entsprechenden Wert unterschreitet.

**8.** Vorrichtung nach Anspruch 7,
dadurch **gekennzeichnet**,
dass eine dem zweiten Anzeigeelement vorgeschaltete Gleichspannungpegelausweteschaltung (10) vorgesehen ist, die die elektrische Spannung des Gleichspannungs-Mess-Signals (8A) bewertet und im Falle eines Unterschreitens eines vorbestimmten Spannungsniveaus des Gleichspannungs-Mess-Signals (8A) das zweite Anzeigeelement (9) steuert.

**9.** Vorrichtung nach einem der Ansprüche 1 bis 8,
dadurch **gekennzeichnet**,
dass eine Restladungstest-Schaltung (16) vorgesehen ist, die eine elektrische Ladung des zu prüfenden Elektrolyt-Kondensators (2) detektiert und an ihrem Ausgang ein entsprechendes Signal (16A) liefert.

**10.** Vorrichtung nach einem der Ansprüche 1 bis 9,
dadurch **gekennzeichnet**,
dass das Anzeigeelement und/oder das zweite Anzeigeelement eine Anzeigevorrichtung (17) mit mehreren, insbesondere drei einzelnen optischen Anzeigeeinheiten (17a bis 17c) ist.

**11.** Vorrichtung nach einem der Ansprüche 5 bis 10,
dadurch **gekennzeichnet**,
dass der Prozessor (51) mit der Restladungstest-Schaltung (16) und/oder mit der Widerstandstest-Schaltung (15) verbunden ist und steuert entsprechend deren Signale (15A, 16A) die Anzeigevorrichtung.

**12.** Vorrichtung nach einem der Ansprüche 1 bis 11,
dadurch **gekennzeichnet**,
dass ein Kontaktorgan (7) vorgesehen ist, vermittels welchem die Wechselspannung und/oder die Gleichspannung an die eine Elektrode (21) des zu prüfenden Elektrolyt-Kondensators (2) zugeführt ist und das insbesondere durch eine elektrisch mit der Vorrichtung (1) verbundene metallene Messspitze ausgebildet ist, welche mit der einen Elektrode (21) des zu prüfenden Elektrolyt-Kondensators (2) in Kontakt gebracht ist.

**13.** Verfahren zur Prüfung eines Elektrolyt-Kondensators (2), der in einer Schaltung als Einzelbauelement eingebaut ist, wobei die eine Elektrode (21) des Elektrolyt-Kondensators mit einem Prüfsignal beaufschlagt wird, und die andere Elektrode auf ein Bezugspotenzial (Masse) gesetzt wird,
dadurch **gekennzeichnet**,
dass der zu prüfende Elektrolyt-Kondensator (2) im eingebauten Zustand belassen wird, und die eine Elektrode (21) des Elektrolyt-Kondensators mit einer hochfrequenten Wechselspannung als Prüfsignal beaufschlagt wird und die aufgrund des Scheinwiderstandes am Elektrolyt-Kondensator abfallende Spannung ein Anzeigeelement (6) steuert, wobei das Anzeigeelement ein Unter- oder Überschreiten einer durch ein Referenzteil (3) festgelegten Schwellspannung der durch den Scheinwiderstand des zu prüfenden Elektrolyt-Kondensators (2) abfallenden Spannung durch ein Signal anzeigt.

**14.** Verfahren nach Anspruch 13,
dadurch **gekennzeichnet**,
dass die Schwellspannung die bei einer Unter- oder Überschreitung zur Anzeige des Signals durch das Anzeigeelement (6) führt durch das Referenzteil (3) dergestalt einstellt wird, dass der Scheinwiderstand und damit die Kapazität, der zur Auslösung des Signals führt in Schwellen von beispielsweise 5µF, 10µF, 50µF usw. festgelegt wird.

**15.** Verfahren nach einem der Ansprüche 13 oder 14,
dadurch **gekennzeichnet**,
dass das Prüfsignal eine Gleichspannung ist, und die aufgrund des Serienwiderstandes des zu prüfenden Elektrolyt-Kondensators (2) an diesem abfallende Spannung das erste (6) oder ein zweites Anzeigeelement (9) steuert, wobei das Anzeigeelement (9) ein Unter- oder Überschreiten einer durch einen Referenzwiderstand (8) festgelegten Schwellspannung der durch den Serienwiderstand des zu prüfenden Elektrolyt-Kondensators abfallenden Spannung durch ein Signal anzeigt.

**16.** Verfahren nach einem der Ansprüche 13 bis 15,
dadurch **gekennzeichnet**,
dass die das erste und/oder das zweite Anzeigeelement (6 und 9) steuernden Signale durch einen Prozessor verarbeitet und/oder zwischengespeichert und zu einer Gesamtbewertung weiterverarbeitet werden, wobei zuerst die Ladung des zu prüfenden Elektrolyt-Kondensators, danach der Gleichstromwiderstand und hierauf der Scheinwiderstand ermittelt und bewertet wird.

Fig 1

EP 1 026 510 A2

**Fig 2**